# EUROPEAN PATENT SPECIFICATION

(11) **EP 3 696 009 B1**
(45) Date of publication and mention of the grant of the patent: **04.09.2024**
(21) Application number: 19020066.7
(22) Date of filing: 12.02.2019
(51) Int. Cl.: B60L 50/50, B60L 58/22, B60L 3/00, G01R 29/16, H02J 3/26

(54) **METHOD FOR SYMMETRISING A THREE PHASE CURRENT**
VERFAHREN ZUR SYMMETRIERUNG EINES DREIPHASENSTROMS
PROCÉDÉ DE SYMÉTRISATION D'UN COURANT TRIPHASÉ

(43) Date of publication of application: 19.08.2020
(73) Proprietor: Furrer + Frey AG, 3005 Bern (CH)
(72) Inventor: Dschung, Felix, D-67227 Frankenthal (DE)
(74) Representative: von Bülow & Tamada

(56) References cited:
- EP-A1- 2 766 972
- EP-B1- 2 766 972
- WO-A1-2014/101282
- CN-A- 104 527 462
- TANTA MOHAMED ET AL: "Power quality phenomena in electrified railways: Conventional and new trends in power quality improvement toward public power systems", 2018 INTERNATIONAL YOUNG ENGINEERS FORUM (YEF-ECE), IEEE, 4 May 2018 (2018-05-04), pages 25 - 30, XP033352239, DOI: 10.1109/YEF-ECE.2018.8368934
- ANONYMOUS: "Scott-connection transformer / Roof-delta connection transformer | For railways | MEIDENSHA CORPORATION", 25 March 2017 (2017-03-25), XP055866603, Retrieved from the Internet <URL:https://web.archive.org/web/20170325113808/https://www.meidensha.com/products/energy/prod_01/prod_01_05/prod_01_05_05/prod_01_05_05_01/index.html> [retrieved on 20211127]

## Description

The present invention relates to a method according to claim 1, a control device according to claim 5, a train according to claim 6 and a catenary system according to claim 7.

A phase converter converting a three phase current into a two phase current is known from US 3,278,825 A.

Using balanced three-phase power transformers such as scott power transformer in two-phase power connections and in rail distribution networks leading to some harmonics cancellation is known from DOI 10.¹¹⁰⁹/YEF-ECE.2018.8368934.

Document SPI 2 766 972 A1 discloses a three phase converter with three phase legs that are interconnected in a star-configuration. Each phase leg comprises switching cells each comprising semi-conductor switches to selectively provide a connection to a corresponding energy storage element. The three phase converter further includes a controller that monitors the DC voltage of the energy storage elements and controls the switching of each switching cell. Each phase leg of the three phase converter, comprises two parallel branches of switching cells connected to a closed circuit. The voltage levels of each of the energy storage elements are monitored and balanced, wherein the balancing includes circulating a current within the two branches of each phase leg of the multilevel converter.

It is object of the invention to improve application of phase converters in the field of catenary systems.

The object is solved by the features of the independent claims. Advantageous embodiments are subject of the dependent claims.

According to an aspect of the invention, in a method for symmetrising or balancing a three phase current that is converted via a phase converter into a two phase current being composed of a first phase current flowing through a first electrical load and a second phase current flowing through a second electrical load being electrically separated from the first electrical load, at least one of the electrical loads comprises an electric energy storage device in a train for storing electric energy to supply an electric motor in the train, wherein the first and second phase current are set in that a difference between the the absolute value of the first phase current and the absolute value of the second phase current falls below a predefined reliability value.

The invention is based on the thought that currently available electric power cars can be extended by an accumulator to bridge unelectrified sections of rail tracks. The accumulator can be charged during passing electrified sections of the rail tracks or when standing for example at a terminus of a line. The bridgeable distance with currently available accumulators is between 40km and 80km. Such electric power cars equipped with an accumulator will most probably be used on rail tracks in the country side, where the rail operator will be forced to take the electric energy from the medium-voltage power grid.

However, the charging power of a single accumulator train set during standstill is between 1.2 MVA and 2.5 MVA. This electric power will be doubled in case of a double traction train and can thus not be symmetrically taken from the medium-voltage power grid as a single phase load without violating reliability values for an unsymmetrie or unbalance in the medium-voltage power grid e.g. according to EN 50160 or IEC 1000-3-x.

In order to establish a balanced energy extraction from the medium-voltage power grid as best as possible, it is proposed with the provided method to convert the three phase current into a two phase current and to balance the two phases against each other. By that means, it is secured that the energy extraction by the train operator complies with a reliability value, that is at least given by the power grid operator. Therefore, the predefined reliability value should be dependent on a threshold value for an unsymmetrie balance in an electric power supply network providing the three phase current in one embodiment of the provided method.

In a further embodiment of the provided method, the step setting the first and/or second phase current includes the step limiting one of the phase currents based on the other phase current. By that means, it is secured that the energy extraction from the power grid does not result into the need of an unnecessary energy extraction.

In another embodiment of the provided method, the step setting the first and/or second phase current include guiding at least a part of one of the phase currents through an auxiliary load, if the other phase current increases the one of the phase currents. This auxiliary load can preferably be an accumulator. This means allows the extraction of a required electrical energy via one phase current. Surplus electrical energy taken via the other phase current can for example be intermediately stored in the accumulator and used at a later time. Alternatively the auxiliary load can be a further phase converter feeding the electric energy to the primary side of the above mentioned phase converter back into the power grid.

According to another aspect of the invention, a control device is adapted to execute a method according to one of the preceding claims.

In a further embodiment, the control device includes a memory and a processor. Therein, the provided method is stored in the memory as computer program, wherein the processor is adapted to execute the method, when the computer program is loaded from the memory into the processor.

According to another aspect of the invention, a computer program comprises program code means to perform all steps of the provided method, when the computer program is executed on an electrical device or in one of the provided control devices.

According to another aspect of the invention, a computer program product includes a program code that is stored on a computer readable data carrier and that executes the provided method, when it is executed on a data processing system.

According to another embodiment of the invention, a train which is adapted to receive a first phase current from a phase converter that converts a three phase electric current into a two phase electric current with the first phase current and a second phase current, comprises an electric motor; an electric energy storage device that is adapted to receive the first phase current and to supply the electric motor with electric energy; a communication device that is adapted to receive an information about the second phase current; and a provided control device.

According to another aspect of the invention, a catenary system for providing electric energy to electrically driven trains, includes a first catenary section, a second catenary section that is electrically separated or insulated from the first catenary section and a phase converter that is adapted to receive a three phase current from a electric power supply network, to transform the three phase current into a two phase current with a first phase current and a second phase current and to provide the first current to the first catenary section and the second phase current to the second catenary section.

In a further embodiment of the provided catenary system, the phase converter is a Scott transformator.

In a another embodiment, the provided catenary system includes a provided controller.

In an additional embodiment, the provided catenary system includes an electric energy storage device coupled to one of the two catenary sections.

The above described characteristics, features and advantages of this invention as well as the manner and way how they are achieved will get further comprehensive based on following description of the embodiments that will be explained in further detail in connection with the figures. It shows:
Fig. 1 in a schematic view a catenary system that supplies a train with electrical energy,
Fig. 2 in a schematic view a control device in the train of Fig. 1,
Fig. 3 in a schematic view an alternative control device in the train of Fig. 1,
Fig. 4 in a schematic view an alternative catenary system that supplies a train with electrical energy,

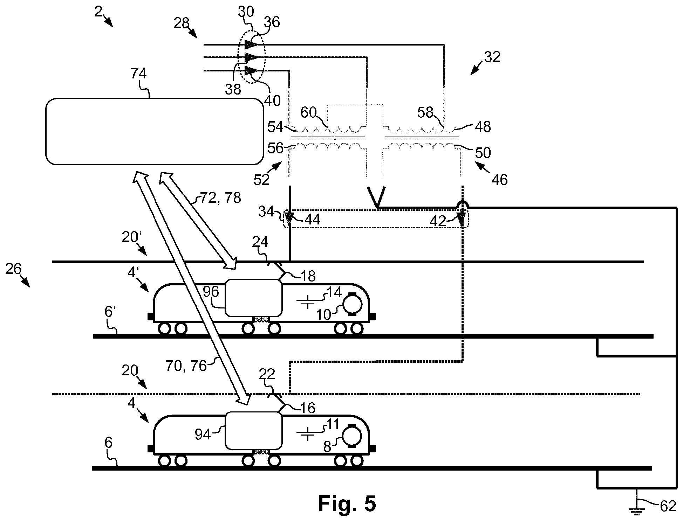

Fig. 5 in a schematic view an alternative catenary system that supplies two trains with electrical energy, and
Fig. 6 in a simplified schematic view of the catenary system of Fig. 5,

In the figures, equal technical elements will be provided with equal reference signs and described only one time. The figures are only of schematic nature and does in particular not disclose any real geometric dimension.

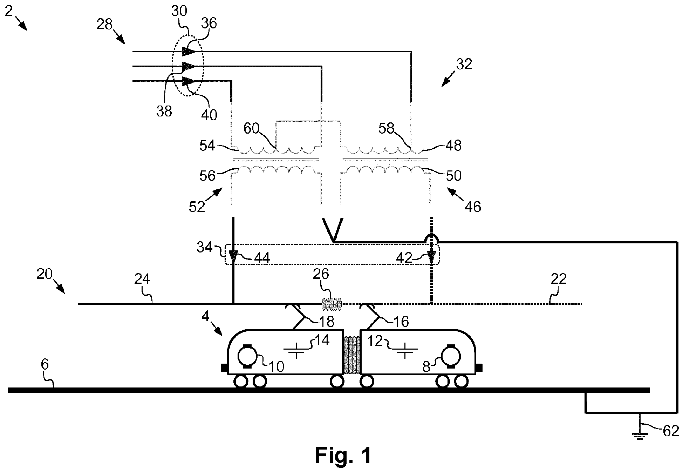

Reference is made to Fig. 1 that shows in a schematic view a catenary system 2 that supplies a train 4 with electrical energy.

The train 4 that is guided on a rail track 6 is driven by a first electric motor 8 and a second electric motor 10. The first electric motor 8 can be supplied with electric energy by a first accumulator 12, while the second electric motor 10 can supplied with electric energy by a second accumulator 14. The first accumulator 12 is loaded with electric energy via a first pantograph 16, while the second accumulator 14 is loaded via a second pantograph 18.

Usually, while the train 4 is on the track 6, both pantographs 16, 18 can get the electric energy to be charged into the accumulators 12, 14 from a catenary 20. In some application scenarios, the catenary 20 is divided into two or more catenary sections 22, 24 that are each electrically separated via a section insulator 26. In such an application scenario, if the first pantograph 16 is positioned below the first catenary section 22 and the second patograph 18 is positioned below the second catenary section 24 as shown in Fig. 1, the first accumulator 12 will be charged via the first catenary section 22, while the second accumulator 14 will be charged via the second catenary section 24. Such a scenario can be kept uphold for a comparably long time, like at a terminus of a line, when the train 4 is waiting for its next mission.

The thought behind the present embodiment is to use the before described scenario to symmetrically take electric energy from a three phase power grid 28 when charging the first and the second accumulator 12, 14. This idea shall be described in further detail hereinafter:
The three phase power grid 28 provides a three phase current 30 feeding a phase converter 32. The phase converter 32 is exemplary embodied as Scott transformer and transforms the three phase current 30 into a two phase current 34 that itself supplies the catenary 20.

The three phase current 30 that is input into the phase converter 32 includes a first phase input current 36, a second phase input current 38 and a third phase input current 40, while the phase converter 32 outputs a first phase output current 42 and a second phase output current 44. To convert the three phase current 30 into the two phase current 34, the phase converter 32 includes a first transformator 46 with a first input inductance 48 and a first output inductance 50 and further a second transformator 52 with a second input inductance 54 and a second output inductance 56. All inductances 48 to 56 are electrotechnically equal and wound with an equal inductance winding amount.

The first phase input current 36 is input into the first input inductance 48 at a first center tap 58 that is located at an winding amount of √3/2 of the complete winding amount of the first input inductance 48. The side opposite of the first center tap 58 of the first input inductance 48 is connected to a second center tap 60 in the middle of the second input inductance 54. The first output inductances 50 is connected between the first catenary 22 and ground 62, whereas the second output inductances 56 is connected between the second catenary 24 and ground 62 in such a way, that both output inductances 50, 56 are connected to each other in a starshape way.

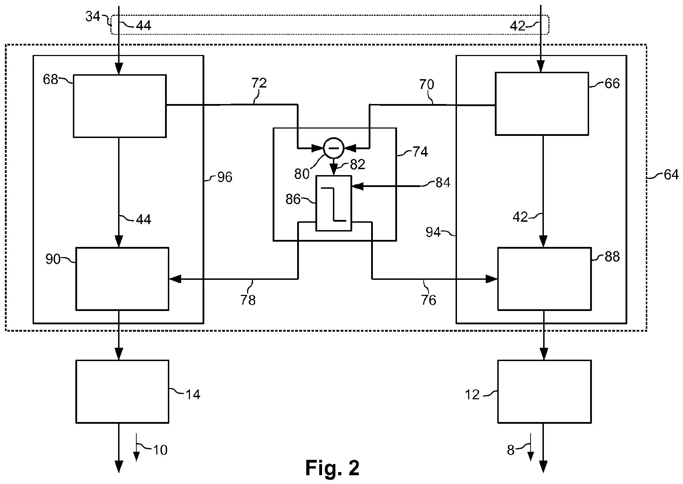

To realize the above mentioned idea to symmetrically take energy from the three phase power grid 28, the train 4 includes a control device 64, which structure is shown in Fig. 2. This structure is only provided as example and should not limit the basic idea behind the invention in any way.

The control device 64 measures the converted two phase current 34 and determines, whether the converted two phase current 34 results from an unsymmetric three phase current 30. In case, the converted two phase current 34 results from an unsymmetric three phase current 30, the control device 64 amends the two phase current 34 to symmetrise the three phase current 30.

In the present embodiment, the control device 64 therefore includes a first measuring equipment 66 for measuring the first phase output current 42 and a second measuring equipment 68 for measuring the second phase output current 44. The first measuring equipment 66 outputs a first current value 70 that reflects a measuring value for the first phase output current 42. The first current value 70 can reflect the first phase output current 42 in an arbitrary way, like as mean value over a predefined time, as effective value over a predefined time, as instantaneous value, etc. Analogously to the first measuring equipment 66, the second measuring equipment 68 outputs a second current value 72 that reflects a measuring value for the second phase output current 44.

The control device 64 further includes a comparison equipment 74 that is adapted to compare measured current values 70, 72 and to output a first adjustment signal 76 or a second adjustment signal 78 that controls the above mentioned symmetrisation. For outputting the adjustment signals 76, 78, the comparison equipment 74 includes a comparison element 80 that is embodied as subtraction element in Fig. 2. The output of the comparison element is a comparison value 82 that indicates with its sign, which of the measured current values 70, 72 is larger and based on its absolute value the difference between the measured current values 70, 72. The comparison equipment 74 further includes a determination element 86 that defines based on a reliability value 84. In the present embodiment, the reliability value 84 is a limit for the before mentioned absolute value of the comparison value 82, that is between the measured current values 70, 72, upon which an unsymmetrie in the three phase current 30 raises for example security criteria of the provider of the three phase current 30. In contrast, the sign in the comparison value 82 indicates whether the the first measured current value 70 or the second measured current value 72 is too high to keep within the security criteria of the provider of the three phase current 30. Based on this information, the determination element 86 outputs either the first adjustment signal 76 or the second adjustment signal 78.

The control device 64 further includes a first control element 88 in the path of the first phase output current 42 and a second control element 90 in the path of the second phase output current 44. These control elements 88, 90 can be exemplary embodied as current limiters that limit the respective phase output current 42, 44 based on the first or second adjustment signal 76, 78 in a way, that the security criteria of the provider of the three phase current 30 is kept. In detail, if the comparison value 82 indicates that the first phase output current 42 is too high, the comparison equipment 74 controls with the first adjustment signal 76 the first control element 88 to limit the first phase output current 42 to a current value 70 that is within the security criteria or technical connection condition of the provider of the three phase current 30. If in contrast the comparison value 82 indicates that the second phase output current 44 is too high, the comparison equipment 74 controls with the second adjustment signal 78 the second control element 90 to limit the second phase output current 44 to a current value 72 that is within the security criteria of the provider of the three phase current 30.

By that means, the accumulators 12, 14 in the train 4 can be charged with a symmetric current drain from the three phase power grid 28, if rectified.

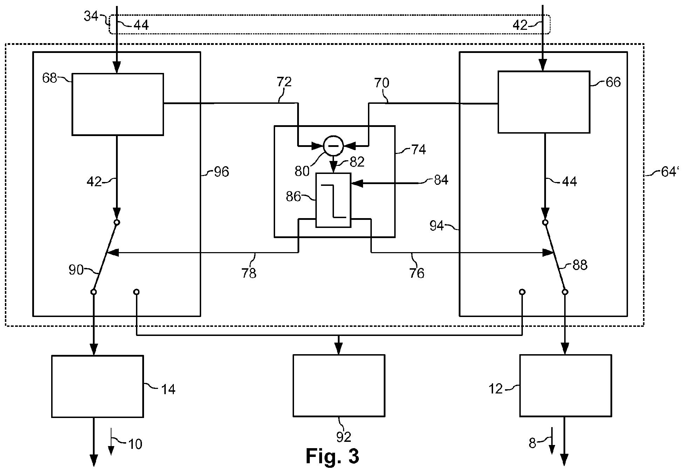

The disadvantage of the control device 64 of Fig. 2 is that an unbalanced current drain from the three phase power grid 28 will usually occur, if either the first accumulator 12 or the second accumulator 14 is fully charged, such that the charging current of the respectively other accumulator 14, 12 must be limited in order to respect the technical connection conditions. To fully charge both accumulators 12, 14, an alternative control device 64' is proposed in Fig. 3.

This alternative control device 64' includes instead of current limiters switches as control elements 88, 90 that guide the output phase current 42, 44 that is too high according to the before mentioned criteria to an auxiliary load 92. The auxiliary load 92 can be a third accumulator or any other electric energy consumer that is able to adsorb the exceeding electric energy.

By that means, it is ensured that both, the first accumulator 12 as well as the second accumulator 14 can be fully charged.

In Figs. 2 and 3, it is assumed that the described control devices 64 are located in one single railcar of the train 4. However, the invention can also be practiced on different railcars of the train 4 or even on different trains. To describe this possibility in further detail, the first measuring equipment 66 and the first control element 88 forms a first current control equipment 94, whereas the second measuring equipment 66 and the second control element 90 forms a second current control equipment 96.

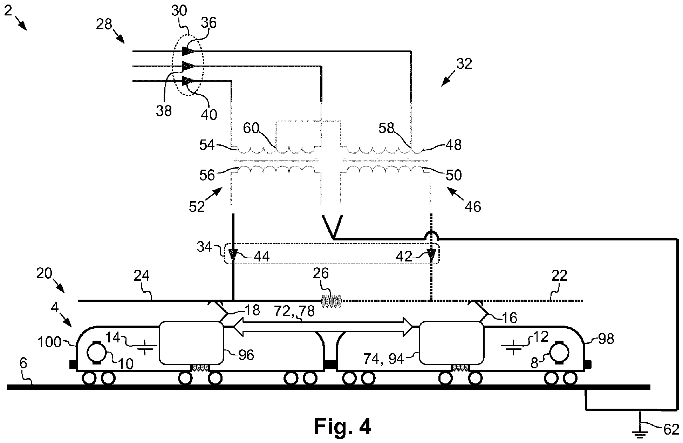

An embodiment to implement the invention on different railcars of the train 4 is shown in Fig. 4.

Therein, the comparison equipment 74 and the first current control equipment 94 can be located in a first railcar 98 of the train 4 with the first pantograph 16. In a second railcar 100 of the train 4 with the second panthograph 18, the second current control equipment 96 can be located.

To facilitate the invention, in the above described way, it is only required to establish an information connection or communication link between the first railcar 98 and the second railcar 100 to exchange the second measured current value 72 and the second adjustment signal 78.

The auxiliary load 92 according to Fig. 3 can be provided either in one of the railcars 98, 100 or stationary regarded to the train 4. An electric power line between the railcars 98, 100 and the auxiliary load 92 must be installed in an application dependent way.

Analogously to Fig. 4, the the first current control equipment 94 can be located in the train 4 with the first pantograph 16, wherein the second current control equipment 96 can be located in another train 4' with the second pantograph 18 that is located on another track 6' and takes electric energy from another catenary 20'. The section insulator 26 will thus be the air between the two catenaries 20, 20'.

Indeed, the comparison equipment 74 can be located in one of the trains 4, 4', it is also possible to locate the comparison equipment 74 at a common coordination center. As described in line with Fig. 4, the auxiliary load 92 can also be located in one of the trains 4, 4' or stationary to all trains 4, 4'.

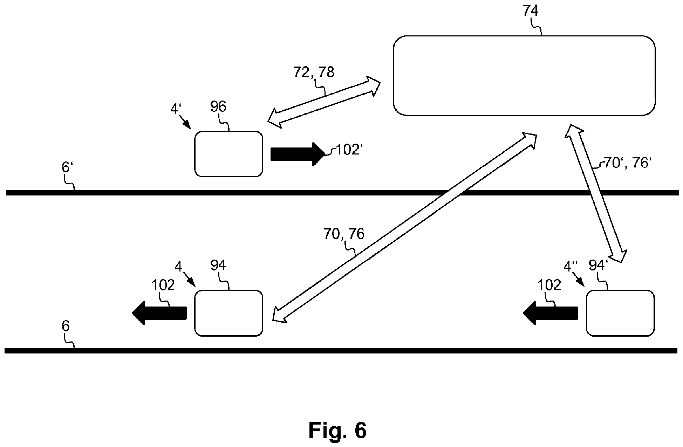

Locating the comparison equipment 74 at a common coordination center allows further controlling the symmetric current drain from the three phase power grid 28 even for running trains 4, 4' by guiding surplus electric current to other trains running on a same track. This should be explained in fore detail by referring to Fig. 6.

If one of the trains 4 runs in a first direction 102 and the other train 4' runs into another direction 102', for example diametrically to the first train 4 and the drain of electric current by the first train 4 is too less for a symmetric drain of electric current from the three phase power grid 28, it is also possible to let a third train 4" drain this remaining electric energy and keep the electric drain from the three phase power grid 28 symmetric. This nevertheless requires an own current control equipment 94' in the third train 4" with a respective communication link to the comparison equipment 74 to exchange an own measured current value 70' and an own adjustment signal 76'.

## Claims

1. Method for symmetrising a three phase current (30) that is converted via a phase converter (32) into a two phase current (34) composed of a first phase current (42) flowing through a first electrical load (12, 16) and a second phase current (44) flowing through a second electrical load (14, 18) electrically separated from the first electrical load (12, 16), wherein at least one of the electrical loads (12, 16; 14, 18) comprises an electric energy storage device (12, 14) in a train (4, 4') for storing electric energy to supply an electric motor (8, 10) in the train (4, 4'), and **characterised in that** at least one of the first and second phase current (42, 44) is set (88, 90) **in that** a difference (82) between the absolute value of the first phase current (42) and the absolute value of the second phase current (44) falls below a predefined reliability value (84).

2. Method according to claim 1, wherein the predefined reliability value (84) is dependent on a threshold value for an asymmetric balance in an electric power supply network (28) providing the three phase current (30).

3. Method according to claim 1 or 2, wherein setting (88, 90) at least one of the first and second phase current (42, 44) include limiting one of the phase currents (42, 44) based on the other phase current (44, 42).

4. Method according to claim 1 or 2, wherein setting (88, 90) at least one of the first and second phase current (42, 44) include guiding at least a part of one of the phase currents (42, 44) through an auxiliary load (92), if the other phase current increases the one of the phase currents.

5. Control device (64, 64') **characterised in that** it +he+ is adapted to execute a method according to one of the preceding claims.

6. Train (4) that is adapted to receive a first phase current (42) from a phase converter (32) that converts a three phase electric current (30) into a two phase electric current (34) with the first phase current (42) and a second phase current (44), comprising:
- a control device (64, 64') according to claim 5;
- an electric motor (8);
- an electric energy storage device (12) that is adapted to receive the first phase current (42) and to supply the electric motor (8) with electric energy; and
- a communication device that is adapted to receive information about the second phase current (44).

7. Catenary system for providing electric energy to electrically driven trains (4, 4', 4"), including a first catenary section (20), a second catenary section (28') that is electrically separated from the first catenary section (28), the catenary system being **characterised in that** it further comprises a phase converter (32) that is adapted to receive a three phase current (30) from a electric power supply network (28), to transform the three phase current (30) into a two phase current (34) with a first phase current (42) and a second phase current (44) and to provide the first phase current (42) to the first catenary section (28) and the second phase current (44) to the second catenary section (28').

8. Catenary system according to claim 7, wherein the phase converter (32) is a Scott transformator.

9. Catenary system according to claim 7 or 8, including a control device (64, 64') according to claim 5.

10. Catenary system according to one of the claims 7 to 9, including an electric energy storage device (92) coupled to at least one of the two catenary sections (28, 28').

## Patentansprüche

1. Verfahren zur Symmetrisierung eines über einen Phasenwandler (32) in einen Zweiphasenstrom (34) umgewandelten Dreiphasenstroms (30), bestehend aus einem ersten Phasenstrom (42), der durch eine erste elektrische Last (12, 16) fließt, und einem zweiten Phasenstrom (44), der durch eine zweite elektrische Last (14, 18) fließt, die elektrisch von der ersten elektrischen Last (12, 16) getrennt ist, wobei mindestens eine der elektrischen Lasten (12, 16; 14, 18) ein elektrisches Energiespeichergerät (12, 14) in einem Zug (4, 4') umfasst, um elektrische Energie zu speichern, um einen Elektromotor (8, 10) im Zug (4, 4') zu versorgen, **dadurch gekennzeichnet, dass** mindestens einer der ersten und zweiten Phasenströme (42, 44) so eingestellt ist (88, 90), dass ein Unterschied (82) zwischen dem Absolutwert des ersten Phasenstroms (42) und dem Absolutwert des zweiten Phasenstroms (44) unter einen vordefinierten Zuverlässigkeitswert (84) fällt.

2. Verfahren nach Anspruch 1, wobei der vordefinierte Zuverlässigkeitswert (84) von einem Schwellenwert für ein asymmetrisches Gleichgewicht in einem das Dreiphasenstromnetz (28) bereitstellenden elektrischen Versorgungsnetz (30) abhängt.

3. Verfahren nach Anspruch 1 oder 2, wobei das Einstellen (88, 90) mindestens eines der ersten und zweiten Phasenströme (42, 44) das Begrenzen eines der Phasenströme (42, 44) basierend auf dem anderen Phasenstrom (44, 42) umfasst.

4. Verfahren nach Anspruch 1 oder 2, wobei das Einstellen (88, 90) mindestens eines der ersten und zweiten Phasenströme (42, 44) das Führen eines Teils eines der Phasenströme (42, 44) durch eine Hilfslast (92) umfasst, wenn der andere Phasenstrom den einen der Phasenströme erhöht.

5. Steuergerät (64, 64') **dadurch gekennzeichnet, dass** es angepasst ist, ein Verfahren nach einem der vorhergehenden Ansprüche auszuführen.

6. Zug (4), der angepasst ist, einen ersten Phasenstrom (42) von einem Phasenwandler (32) zu empfangen, der einen Dreiphasenstrom (30) in einen Zweiphasenstrom (34) mit dem ersten Phasenstrom (42) und einem zweiten Phasenstrom (44) umwandelt, umfassend:
- ein Steuergerät (64, 64') nach Anspruch 5;
- einen Elektromotor (8);
- ein elektrisches Energiespeichergerät (12), das angepasst ist, den ersten Phasenstrom (42) zu empfangen und den Elektromotor (8) mit elektrischer Energie zu versorgen; und
- ein Kommunikationsgerät, das angepasst ist, Informationen über den zweiten Phasenstrom (44) zu empfangen.

7. Oberleitungssystem zur Bereitstellung elektrischer Energie für elektrisch betriebene Züge (4, 4', 4"), umfassend einen ersten Oberleitungsabschnitt (20), einen zweiten Oberleitungsabschnitt (28'), der elektrisch vom ersten Oberleitungsabschnitt (28) getrennt ist, wobei das Oberleitungssystem **dadurch gekennzeichnet ist, dass** es weiterhin einen Phasenwandler (32) umfasst, der angepasst ist, einen Dreiphasenstrom (30) von einem elektrischen Versorgungsnetz (28) zu empfangen, um den Dreiphasenstrom (30) in einen Zweiphasenstrom (34) mit einem ersten Phasenstrom (42) und einem zweiten Phasenstrom (44) umzuwandeln und den ersten Phasenstrom (42) dem ersten Oberleitungsabschnitt (28) und den zweiten Phasenstrom (44) dem zweiten Oberleitungsabschnitt (28') bereitzustellen.

8. Oberleitungssystem nach Anspruch 7, wobei der Phasenwandler (32) ein Scott-Transformator ist.

9. Oberleitungssystem nach Anspruch 7 oder 8, umfassend ein Steuergerät (64, 64') nach Anspruch 5.

10. Oberleitungssystem nach einem der Ansprüche 7 bis 9, umfassend ein elektrisches Energiespeichergerät (92), das mit mindestens einem der beiden Oberleitungsabschnitte (28, 28') gekoppelt ist.

## Revendications

1. Procédé de symétrisation d'un courant triphasé (30) qui est converti via un convertisseur de phase (32) en un courant biphasé (34) composé d'un premier courant de phase (42) circulant à travers une première charge électrique (12, 16) et d'un second courant de phase (44) circulant à travers une seconde charge électrique (14, 18) électriquement séparée de la première charge électrique (12, 16), dans lequel au moins une des charges électriques (12, 16 ; 14, 18) comprend un dispositif de stockage d'énergie électrique (12, 14) dans un train (4, 4') pour stocker de l'énergie électrique afin d'alimenter un moteur électrique (8, 10) dans le train (4, 4'), **caractérisé en ce qu'**au moins l'un des premier et second courants de phase (42, 44) est réglé (88, 90) de sorte qu'une différence (82) entre la valeur absolue du premier courant de phase (42) et la valeur absolue du second courant de phase (44) soit inférieure à une valeur de fiabilité prédéfinie (84).

2. Procédé selon la revendication 1, dans lequel la valeur de fiabilité prédéfinie (84) dépend d'une valeur seuil pour un déséquilibre asymétrique dans un réseau d'alimentation électrique (28) fournissant le courant triphasé (30).

3. Procédé selon la revendication 1 ou 2, dans lequel le réglage (88, 90) d'au moins l'un des premier et second courants de phase (42, 44) comprend la limitation de l'un des courants de phase (42, 44) en fonction de l'autre courant de phase (44, 42).

4. Procédé selon la revendication 1 ou 2, dans lequel le réglage (88, 90) d'au moins l'un des premier et second courants de phase (42, 44) comprend le guidage d'une partie de l'un des courants de phase (42, 44) à travers une charge auxiliaire (92), si l'autre courant de phase augmente l'un des courants de phase.

5. Dispositif de contrôle (64, 64') **caractérisé en ce qu'**il est adapté pour exécuter un procédé selon l'une des revendications précédentes.

6. Train (4) adapté pour recevoir un premier courant de phase (42) d'un convertisseur de phase (32) qui convertit un courant électrique triphasé (30) en un courant biphasé (34) avec le premier courant de phase (42) et un second courant de phase (44), comprenant :
- un dispositif de contrôle (64, 64') selon la revendication 5 ;
- un moteur électrique (8) ;
- un dispositif de stockage d'énergie électrique (12) qui est adapté pour recevoir le premier courant de phase (42) et pour fournir de l'énergie électrique au moteur électrique (8) ; et
- un dispositif de communication qui est adapté pour recevoir des informations sur le second courant de phase (44).

7. Système de caténaire pour fournir de l'énergie électrique à des trains électriques (4, 4', 4"), comprenant une première section de caténaire (20), une seconde section de caténaire (28') qui est électriquement séparée de la première section de caténaire (28), le système de caténaire étant **caractérisé en ce qu'**il comprend en outre un convertisseur de phase (32) qui est adapté pour recevoir un courant triphasé (30) d'un réseau d'alimentation électrique (28), pour transformer le courant triphasé (30) en un courant biphasé (34) avec un premier courant de phase (42) et un second courant de phase (44) et pour fournir le premier courant de phase (42) à la première section de caténaire (28) et le second courant de phase (44) à la seconde section de caténaire (28').

8. Système de caténaire selon la revendication 7, dans lequel le convertisseur de phase (32) est un transformateur Scott.

9. Système de caténaire selon la revendication 7 ou 8, comprenant un dispositif de contrôle (64, 64') selon la revendication 5.

10. Système de caténaire selon l'une des revendications 7 à 9, comprenant un dispositif de stockage d'énergie électrique (92) couplé à au moins une des deux sections de caténaire (28, 28').
